# EUROPÄISCHE PATENTSCHRIFT

(11) **EP 3 179 521 B1**
(45) Veröffentlichungstag und Bekanntmachung des Hinweises auf die Patenterteilung: **23.08.2023**
(21) Anmeldenummer: 16002554.0
(22) Anmeldetag: 01.12.2016
(51) Int. Cl.: H01L 31/041, H01L 31/0687, H01L 31/0304, H01L 31/054

(54) **MEHRFACH-SOLARZELLE**
MULTIJUNCTION SOLAR CELL
CELLULE SOLAIRE À JONCTIONS MULTIPLES

(30) Priorität: 10.12.2015 DE 102015016047
(43) Veröffentlichungstag der Anmeldung: 14.06.2017
(73) Patentinhaber: AZUR SPACE Solar Power GmbH, 74072 Heilbronn (DE)
(72) Erfinder: Ebel, Lars, 97249 Eisingen (DE); Guter, Wolfgang, 70190 Stuttgart (DE); Meusel, Matthias, 74076 Heilbronn (DE)
(74) Vertreter: Koch Müller Patentanwaltsgesellschaft mbH

(56) Entgegenhaltungen:
- EP-A1- 2 960 950
- EP-A2- 1 109 230
- EP-A2- 1 134 813
- US-A1- 2002 195 137
- US-A1- 2005 155 641
- US-A1- 2006 144 435
- US-B1- 6 660 928

## Beschreibung

Die Erfindung betrifft eine Mehrfach-Solarzelle mit fünf Teilzellen.

Aus der Druckschrift "Current-matched triple-junction solar cell reaching 41.1% conversion efficiency under concentrated sunlight" von Guter et al., Applied Physics Letters 94, 223504 (2009) ist eine Mehrfach-Solarzelle (engl. multi-junction solar cell) bekannt. Bei der offenbarten Struktur handelt es sich um eine metamorphe Ga_{0.35}In_{0.65}P/Ga₀.₈₃In_{0.17}As/Ge Dreifach-Solarzelle mit hohem Wirkungsgrad. Zwischen dem Ge Substrat bzw. der Ge Teilzelle und der Ga_{0.83}In_{0.17}As Teilzelle wird ein metamorpher Puffer aus Ga_{Y}In_{1-Y}As verwendet.

Weiterhin sind aus der Druckschrift "Development of Advanced Space Solar Cells at Spectrolab" von Boisvert et al. in Proc. of 35th IEEE PVSC, Honolulu, HI, 2010, ISBN: 978-1-4244-5891-2, auf Halbleiterbond-Technologie basierende GaInP/GaAs/GaInAsP/GaInAs Vierfach- und GaInP/AlGaInAs/GaAs/ GaInAsP/GaInAs Fünffach-Solarzellen bekannt. Eine weitere Vierfach-Solarzelle ist auch aus der Druckschrift "Wafer bonded four-junction GaInP/GaAs/GaInAsP/GaInAs concentrator solar cells with 44.7% efficiency" von Dimroth et al. in Progr. Photovolt: Res. Appl. 2014; 22: 277-282, bekannt.

In den zuletzt genannten beiden Druckschriften werden ausgehend von einem InP Substrat jeweils GaInAsP Solarzellen mit einer Energiebandlücke von ca. 1.0 eV gitterangepasst abgeschieden. Die oberen Solarzellen mit höherer Bandlücke werden in einer zweiten Abscheidung in invertierter Reihenfolge auf einem GaAs Substrat hergestellt. Die Bildung der gesamten Mehrfach-Solarzelle geschieht durch einen direkten Halbleiterbond der beiden Epitaxiewafer, mit einer anschließenden Entfernung des GaAs Substrates und weiteren Prozessschritten. Der Herstellungsprozess ist jedoch kostenintensiv.

Aus der EP 1 109 230 A2, der US 6 660 928 A1, der US 2006 / 144 435 A1, der US 2005 / 155 641 A1, der EP 1134 813 A2 und der US 2002 / 195137 A1 sind weitere Mehrfachzellen bekannt.

Aus der DE 10 2012 004 734 A1 ist eine sowohl auf Halbleiterbond-Technologie als auch auf metamorpher Epitaxie basierende GaInP/GaAs/ GaInAs/Puffer/Ge Vierfach-Solarzelle bekannt. Die Herstellungskosten sind aufgrund der zwei notwendigen Abscheidungen auf zwei separaten Substraten, der notwendigen Substratentfernung und des notwendigen Bond-Prozesses immer noch hoch. Ferner sind aus der EP 1 134 813 A2, der EP 2 960 950 A1 (dieses Dokument fällt unter A. 54(3) EPÜ) und der DE 10 2005 000 767 A1 Mehrfachsolarzellen ohne Halbleiterbond bekannt.

Die Optimierung der Strahlungshärte, insbesondere auch für sehr hohe Strahlungsdosen, ist ein wichtiges Ziel bei der Entwicklung zukünftiger Raumfahrtsolarzellen. Ziel ist es neben der Steigerung des Anfangs- bzw. beginning-of-life (BOL) Wirkungsgrades auch den end-of-life (EOL) Wirkungsgrades zu erhöhen.

Weiterhin sind die Herstellungskosten von entscheidender Bedeutung. Der industrielle Standard zum Zeitpunkt der Erfindung ist durch gitterangepasste und die metamorphe GaInP/GaInAs/Ge Dreifach-Solarzellen gegeben. Hierzu werden durch Abscheidung der GaInP Ober- und GaInAs Mittel-Zelle auf ein relativ zu GaAs- und InP-Substraten kostengünstiges Ge Substrat MehrfachSolarzellen hergestellt, wobei das Ge-Substrat die Unterzelle bildet.

Vor diesem Hintergrund besteht die Aufgabe der Erfindung darin, eine Vorrichtung anzugeben, die den Stand der Technik weiterbildet.

Die Aufgabe wird durch eine Mehrfach-Solarzelle mit den Merkmalen des Patentanspruchs 1 gelöst. Vorteilhafte Ausgestaltungen der Erfindung sind Gegenstand von Unteransprüchen.

Gemäß dem Gegenstand der Erfindung wird eine stapelförmige Mehrfach-Solarzelle mit einer ersten Teilzelle bereitgestellt, wobei die erste Teilzelle überwiegend Germanium aufweist, und mit einer zweiten Teilzelle, wobei die zweite Teilzelle eine größere Bandlücke als die erste Teilzelle aufweist, und mit einer dritten Teilzelle, wobei die dritte Teilzelle eine größere Bandlücke als die zweite Teilzelle aufweist, und jede der Teilzellen einen Emitter und eine Basis aufweist, und wobei die zweite Teilzelle eine Schicht mit einer Verbindung mit wenigstens den Elementen Ga und In und As und P umfasst und die Dicke der

Schicht größer als 100 nm ist und die Schicht als Teil des Emitters und / oder als Teil der Basis und / oder als Teil der zwischen Emitter und Basis liegenden Raumladungszone ausgebildet ist, die dritte Teilzelle eine Schicht mit einer Verbindung mit wenigstens den Elementen Al und Ga und In und aufweist und die Dicke der Schicht größer als 100 nm ist und die Schicht als Teil des Emitters und / oder als Teil der Basis und / oder als Teil der zwischen Emitter und Basis liegenden Raumladungszone ausgebildet ist, und bei der zweiten Teilzelle der Phosphor-Gehalt der Schicht größer 1% und kleiner 45% ist und der Indium-Gehalt der Schicht kleiner 50% ist, und die Gitterkonstante der Schicht kleiner 5,84 Å ist, und die Gitterkontante der Schicht der dritten Teilzelle sich von der Gitterkontante der Schicht der zweiten Teilzelle um weniger als 0,2% unterscheidet, und zwischen zwei Teilzellen der Mehrfach-Solarzelle kein Halbleiterbond ausgebildet ist.

Es versteht sich, dass insbesondere der angegebene Phosphor-Gehalt auf den Gesamtgehalt der Gruppe-V Atome bezogen ist. Entsprechend ist der angegebene Indium-Gehalt auf den Gesamtgehalt der Gruppe-III Atome bezogen. D.h. bei der Verbindung Ga_{1-X}In_{X}As_{1-Y}P_{Y} beträgt der Indium-Gehalt den Wert X und der Phosphor-Gehalt den Wert Y und hierdurch ergibt sich für einen Phosphor-Gehalt von 50% ein Y-Wert von 0,5.

Auch sei angemerkt, dass zwei unmittelbar aufeinanderfolgende Teilzellen unterschiedliche Elemente aufweisen.

Es sei angemerkt, dass mit dem Begriff "Halbleiterbond" insbesondere umfasst ist, dass zwischen zwei beliebigen Teilzellen des Solarzellenstapels auch kein direkter Halbleiterbond ausgebildet ist. D.h. der Solarzellestapel wird nicht aus zwei Teilstapeln hergestellt, welche auf unterschiedlichen Substraten abgeschieden wurden und nachträglich über einen Halbleiterbond zusammengefügt sind. Insbesondere weist der Solarzellenstapel keine amorphen Zwischenschichten auf.

Es versteht sich, dass die Mehrfach-Solarzelle monolithisch aufgebaut ist. Auch wird angemerkt, dass in jeder der Solarzellen der Mehrfach-Solarzelle eine Absorption von Photonen und hierdurch eine Generation von Ladungsträgern stattfindet, wobei das Sonnenlicht immer zuerst durch die Teilzelle mit der größten Bandlücke eingestrahlt wird. Anders ausgedrückt, der Solarzellenstapel absorbiert mit der obersten Teilzelle zuerst den kurzwelligen Anteil des Lichtes. Vorliegend durchströmen die Photonen also erst die zweite Teilzelle und anschließend die erste Teilzelle. In einem Ersatzschaltbild sind die einzelnen Solarzellen der Mehrfach-Solarzelle in Serie verschaltet, d.h. die Teilzelle mit dem geringsten Strom wirkt limitierend.

Auch sei angemerkt, dass unter den Begriffen Emitter und Basis entweder die p-dotierten oder die n-dotierten Schichten in der jeweiligen Teilzelle verstanden werden.

Auch sei angemerkt, dass unter dem Begriff überwiegend Germanium diejenigen Schichten mit einem Germanium Anteil oberhalb 70%, vorzugsweise oberhalb 90% und höchst vorzugsweise oberhalb 95% verstanden werden. Auch sei angemerkt, dass vorliegend die chemischen Abkürzungen von Elementen synonym zu den vollständigen Begriffen verwendet werden.

Ein Vorteil der Ausbildung einer ersten Teilzelle überwiegend aus Germanium, besteht darin, dass sich die erste Teilzelle einfach und kostengünstig durch Aktivierung des Germanium Substrates mittels As- und / oder P-Diffusion während des Prozesses der metallorganischen Gasphasenepitaxie (MOVPE) herstellen lässt.

Insbesondere müssen für eine Ausbildung der ersten Teilzelle keine mehreren Mikrometer dicken Schichten aus Germanium, d.h. sogenannte Bulk-Schichten, zur Absorption der Photonen epitaktisch abgeschieden werden. Hierdurch weist die erste Teilzelle geringe Herstellungskosten auf. Untersuchungen haben gezeigt, dass eine Teilzelle aus Germanium eine geringe Degradation unter Bestrahlung mit 1 MeV Elektronen aufweist. Es sei angemerkt, dass unter dem Begriff Germanium Schichten, Schichten mit überwiegend Germanium verstanden werden.

Weiterhin vorteilhaft ist, wie Untersuchungen zeigten, dass die Ausbildung einer zweiten Teilzelle bestehend aus einer Verbindung aus GaInAsP eine höhere Strahlungsstabilität im Vergleich zu Teilzelle aus GaAs, GaInAs, AlGaAs und / oder AlGaInAs aufweist.

Untersuchungen haben überraschend gezeigt, dass im Falle einer Ge, d.h. Germanium, basierten Mehrfach-Solarzelle die Verwendung einer Verbindung überwiegend aus GaInAsP anstelle einer Verbindung aus GaInAs für die zweite Teilzelle aufgrund der höheren Strahlungshärte von GaInAsP gegenüber GaInAs besonders vorteilhaft bereits für Phosphor-Gehalte unter 45% ist. Bisher erschien dem Fachmann die Verwendung einer GaInAsP Zelle abwegig, denn eine zu Germanium gitterangepasst ausgebildete GaInAsP Teilzelle besitzt im Vergleich zu der bisher verwendeten GaInAs Teilzelle eine höhere Energiebandlücke. Hierdurch sinkt bei der Ausbildung einer gitterangepassten GaInP/GaInAs(P)/Ge Tripel-Solarzelle der Anfangswirkungsgrad, auch als BOL Wirkungsgrad bezeichnet, der Solarzelle.

Weitere Untersuchungen haben gezeigt, dass es vorteilhaft ist, möglichst wenig Aluminium in Teilzelle einzubauen. Aluminium reagiert sehr leicht auf Reaktor- oder Quellen-Verunreinigungen durch Restfeuchte und / oder Sauerstoff und verschlechtert in einer oxidierten Form die Materialqualität. Hierdurch lässt sich die Ausbeute bei der Herstellung von Mehrfachsolarzellen steigern.

In einer nicht beanspruchten Ausführungsform weist die Mehrfach-Solarzelle genau drei Teilzellen auf. Zusätzlich oder alternativ weist die Schicht der zweiten Teilzelle eine Energiebandlücke im Bereich von 1,2 eV bis 1,3 eV auf.

Erfindungsgemäß besteht die Schicht der dritten Teilzelle aus einer Verbindung mit wenigstens den Elementen Al und Ga und In und P.

Ein Vorteil ist, dass insbesondere die GaInP oder AlGaInP Verbindungen über eine hohe Strahlungsstabilität verfügen.

Erfindungsgemäß ist zwischen der ersten Teilzelle und der zweiten Teilzelle ein metamorpher Puffer ausgebildet ist, wobei der Puffer eine Abfolge von mindestens drei Schichten aufweist und die Gitterkonstante bei der Abfolge in Richtung der zweiten Teilzelle von Schicht zu Schicht ansteigt. Ein Vorteil des metamorphen Puffers ist, dass hierdurch eine größere Einstellmöglichkeit bei der Energiebandlücke der jeweiligen Teilzelle eröffnet wird, d. h. es lassen sich Einschränkungen, wie der sinkende Wirkungsgrad der Teilzelle bei der Ausbildung von besonders strahlungsharten Zellen aufgrund der bei dem steigenden Phosphor-Gehalt steigenden Energiebandlücke kompensieren oder abmildern.

In einer anderen nicht beanspruchten Weiterbildung sind genau vier Teilzellen vorgesehen, wobei vorzugsweise die Schicht der zweiten Teilzelle eine Energlebandlücke im Bereich von 1,43 eV bis 1,6 eV aufweist.

In einer nicht erfindungsgemäßen anderen Ausführungsform ist die vierte Teilzelle zwischen der zweiten Teilzelle und der dritten Teilzelle angeordnet und die Schicht der vierten Teilzelle umfasst eine Verbindung mit wenigstens den Elementen Al und Ga und In und As oder Ga und In und As und P. Vorzugsweise besteht die Schicht der vierten Zelle aus einer AIGaInAs oder einer GaInAsP Verbindung. Ganz allgemein gilt, dass die Dicke der Schicht der vierten Teilzelle größer als 100 nm ist und die Schicht der vierten Teilzelle als Teil des Emitters und / oder als Teil der Basis und / oder als Teil der zwischen Emitter und Basis liegenden Raumladungszone ausgebildet ist.

In einer nicht erfindungsgemäßen anderen Ausführungsform ist die vierte Teilzelle zwischen der ersten Teilzelle und der zweiten Teilzelle angeordnet und eine Schicht aus einer Verbindung mit wenigstens den Elementen GaInAs oder GaInNAs aufweist und die Dicke der Schicht größer als 100 nm ist und die Schicht als Teil des Emitters und / oder als Teil der Basis und / oder als Teil der zwischen Emitter und Basis liegenden Raumladungszone ausgebildet ist.

In einer Weiterbildung ist ein Halbleiterspiegel ausgebildet, wobei der Halbleiterspiegel zwischen der ersten Teilzelle und der zweiten Teilzelle und / oder zwischen der ersten Teilzelle und der vierten Teilzelle angeordnet ist. Es versteht sich, dass in einer anderen Weiterbildung weitere Halbleiterspiegel zwischen weiteren Teilzellen ausbilden lassen.

In einer anderen Ausführungsform besteht die Schicht der zweiten Teilzelle oder die Schicht der vierten Teilzelle aus einer Verbindung mit wenigstens den Elementen Al und Ga und In und As und P.

Erfindungsgemäß weist die Mehrfach-Solarzelle genau fünf Teilzellen auf und / oder die Schicht der zweiten Teilzelle eine Energiebandlücke im Bereich von 1,3 eV bis 1,4 eV oder im Bereich von 1,43 eV bis 1,7 eV auf.

Erfindungsgemäß ist eine fünfte Teilzelle zwischen der vierten Teilzelle und der dritten Teilzelle angeordnet. Die fünfte Teilzelle weist eine Schicht mit einer Verbindung aus wenigstens den Elementen Ga und In und P auf, wobei die Dicke der Schicht der fünften Teilzelle größer als 100 nm ist und die Schicht der fünften Teilzelle als Teil des Emitters und / oder als Teil der Basis und / oder als Teil der zwischen Emitter und Basis liegenden Raumladungszone ausgebildet ist.

In einer anderen nicht erfindungsgemäßen Ausführungsform ist die fünfte Teilzelle zwischen der zweiten Teilzelle und der vierten Teilzelle angeordnet und weist eine Schicht mit einer Verbindung mit wenigstens den Elementen Ga und In und As auf. Die Dicke der Schicht der fünften Teilzelle ist größer als 100 nm und ist als Teil des Emitters und / oder als Teil der Basis und / oder als Teil der zwischen Emitter und Basis liegenden Raumladungszone ausgebildet.

In einer Ausführungsform ist bei der zweiten Solarzelle der Phosphor-Gehalt der Schicht kleiner als 35% und der Indium-Gehalt der Schicht kleiner als 45% und / oder die Gitterkonstante der Schicht kleiner als 5,81 Ä.

In einer Weiterbildung ist bei der zweiten Solarzelle der Phosphor-Gehalt der Schicht kleiner als 25% und der Indium-Gehalt der Schicht kleiner als 45% und / oder die Gitterkonstante der Schicht kleiner als 5,78 Ä.

In einer Ausführungsform ist bei der zweiten Solarzelle die Dicke der Schicht größer als 0,4 µm oder größer als 0,8 µm.

Sogenannte Hetero-Solarzellen mit einem Emitter bestehend aus GaInP und einer Raumladungszone und / oder Basis bestehend aus GaInAs werden nicht als zweite Teilzelle angesehen. Eine Hetero-Solarzellen mit einem Emitter bestehend aus GaInP und einer Raumladungszone und / oder Basis bestehend aus GaInAsP werden jedoch als zweite Teilzelle angesehen.

In einer anderen Weiterbildung werden vorliegend zweite Teilzelle gemeint, die keine Vielfach-Quantentopf-Struktur aufweisen. Insbesondere weist die zweite Teilzelle keine Perioden aus GaInAs/GaAsP in der Raumladungszone auf.

In einer Weiterbildung unterscheidet sich die Gitterkonstante der Schicht der vierten Teilzelle von der Gitterkonstante der Schicht der zweiten Teilzelle um weniger als 0,2%.

In einer Weiterbildung unterscheidet sich die Gitterkonstante der Schicht der fünften Teilzelle von der Gitterkonstante der Schicht der zweiten Teilzelle um weniger als 0,2%.

In einer nicht beanspruchten Weiterbildung sind alle Teilzellen in Bezug zu der Germanium Teilzelle zueinander gitterangepasst.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben auch keine ableitbaren geometrischen Relationen zueinander auf. Darin zeigt:
- Figur 1: einen Querschnitt auf eine nicht erfindungsgemäße Ausführungsform als Tripel-Solarzelle,
- Figur 2a: einen Querschnitt auf eine nicht erfindungsgemäße Ausführungsform als Vierfach-Solarzelle in einer ersten Alternative,
- Figur 2b: einen Querschnitt auf eine nicht erfindungsgemäße Ausführungsform als Vierfach-Solarzelle in einer zweiten Alternative,
- Figur 2c: einen Querschnitt auf eine nicht erfindungsgemäße Ausführungsform als Vierfach-Solarzelle in einer dritten Alternative,
- Figur 2d: einen Querschnitt auf eine nicht erfindungsgemäße Ausführungsform als Vierfach-Solarzelle in einer vierten Alternative,
- Figur 3a: einen Querschnitt auf eine erfindungsgemäße Ausführungsform als Fünffach-Solarzelle in einer ersten Alternative,
- Figur 3b: einen Querschnitt auf eine erfindungsgemäße Ausführungsform als Fünffach-Solarzelle in einer zweiten Alternative,
- Figur 3c: einen Querschnitt auf eine nicht erfindungsgemäße Ausführungsform als Fünffach-Solarzelle in einer dritten Alternative,
- Figur 3d: einen Querschnitt auf eine nicht erfindungsgemäße Ausführungsform als Fünffach-Solarzelle in einer vierten Alternative,
- Figur 3e: einen Querschnitt auf eine nicht erfindungsgemäße Ausführungsform als Fünffach-Solarzelle in einer fünften Alternative,
- Figur 3f: einen Querschnitt auf eine nicht erfindungsgemäße Ausführungsform als Fünffach-Solarzelle in einer sechsten Alternative.

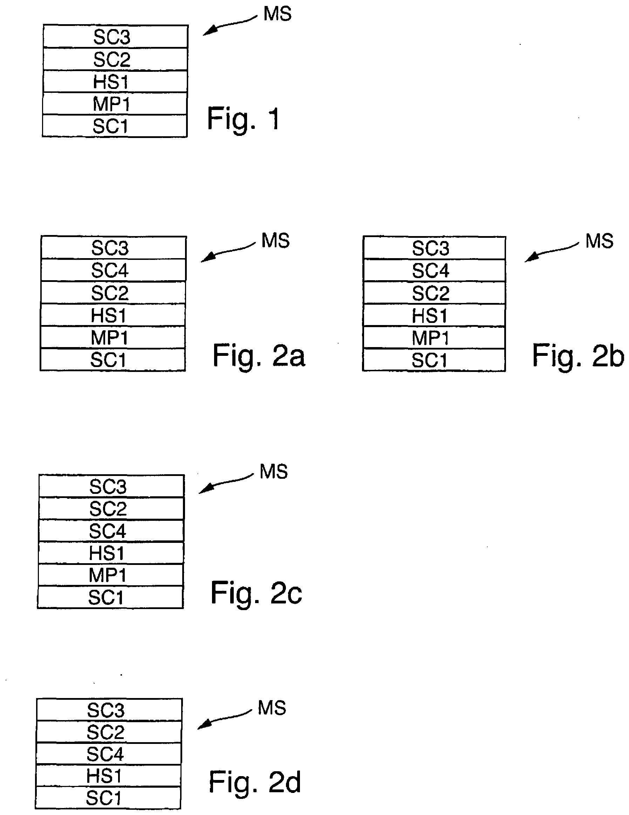

Die Abbildung der Figur 1 zeigt einen Querschnitt auf eine erste nicht erfindungsgemäße Ausführungsform einer stapelförmigen monolithischen Mehrfach-Solarzelle MS, im Folgenden werden die einzelnen Solarzellen des Stapels als Teilzelle bezeichnet. Die Mehrfach-Solarzelle MS weist eine erste Teilzelle SC1 auf, wobei die erste Teilzelle SC1 aus Germanium besteht. Aufliegend auf der ersten Teilzelle SC1 ist eine zweite Teilzelle bestehend aus einer GaInAsP - Verbindung angeordnet. Die zweite Teilzelle SC2 weist eine größere Bandlücke als die erste Teilzelle SC1 auf. Aufliegend auf der zweiten Teilzelle SC2 ist eine dritte Teilzelle bestehend aus einer GaInP - Verbindung oder aus einer AlGaInP - Verbindung angeordnet, wobei die dritte Teilzelle SC3 die größte Bandlücke aufweist. Vorliegend weist die zweite Teilzelle SC2 eine Energiebandlücke zwischen 1.2 eV und 1.3 eV auf.

Zwischen der ersten Teilzelle SC1 und der zweiten Teilzelle SC2 ist ein metamorpher Puffer MP1 und ein Halbleiterspiegel HS1 ausgebildet. Der Puffer MP1 besteht aus einer Vielzahl von im Einzelnen nicht dargestellten Schichten, wobei die Gitterkonstante innerhalb des Puffers MP1 von Schicht zu Schicht des Puffers MP1 in Richtung zu der zweiten Teilzelle SC2 sich im Allgemeinen erhöht. Eine Einführung des Puffers MP1 ist vorteilhaft, wenn die Gitterkonstante der zweiten Teilzelle SC2 nicht mit der Gitterkonstante der ersten Teilzelle SC1 übereinstimmt.

Der Reflektionsverlauf des ersten Halbleiterspiegel HS1 ist auf die Bandlücke der zweiten Teilzelle SC2 abgestimmt. Anders ausgedrückt, diejenigen von der zweiten Teilzelle SC2 absorbierbaren Wellenlängen werden in den Absorptionsbereich der zweiten Teilzelle SC2 zurückreflektiert. Hierdurch lässt sich die Dicke des Absorptionsbereichs der zweiten Teilzelle SC2 wesentlich verringern und die Strahlungsstabilität erhöhen.

Es versteht sich, dass zwischen den einzelnen Teilzelle SC1, SC2 und SC3 jeweils eine Tunneldiode - nicht dargestellt - ausgebildet ist.

Es versteht sich auch, dass jede der drei Teilzellen SC1, SC2 und SC3 jeweils einen Emitter und eine Basis aufweist, wobei die Dicke der zweiten Teilzelle SC2 größer als 0,4 µm ausgebildet ist.

Indem die Bandlücke der ersten Teilzelle SC1 ist kleiner als die Bandlücke der zweiten Teilzelle SC2 und die Bandlücke der zweiten Teilzelle SC2 kleiner als die Bandlücke der dritten Teilzelle SC3 ist, findet die Sonneneinstrahlung durch die Oberfläche der dritten Teilzelle SC3 statt.

Die Figur 2a zeigt einen Querschnitt auf eine nicht erfindungsgemäße Ausführungsform als Vierfach-Solarzelle in einer ersten Alternative. Nachfolgend werden nur die Unterschiede zu der Ausführungsform, dargestellt in Zusammenhang mit der Abbildung 1, erläutert. Zwischen der zweiten Teilzelle SC2 und der dritten Teilzelle SC3 ist eine vierte Teilzelle SC4 bestehend auf einer AlInGaAs - Verbindung ausgebildet. Die Gitterkonstante der zweiten Teilzelle SC2, der vierten Teilzelle SC4 und der dritten Teilzelle SC3 sind zueinander angepasst, bzw. stimmen miteinander überein. Anders ausgedrückt, die Teilzellen SC2, SC4 und SC3 sind zueinander "gitterangepasst". Die vierte Teilzelle SC4 weist eine größere Bandlücke als die zweite Teilzelle SC2 jedoch eine kleinere Bandlücke als die dritte Teilzelle SC3 auf.

Die Figur 2b zeigt einen Querschnitt auf eine nicht erfindungsgemäße Ausführungsform als Vierfach-Solarzelle in einer zweiten Alternative. Nachfolgend werden nur die Unterschiede zu den vorangegangenen Ausführungsformen erläutert. Die vierte Teilzelle SC4 besteht nunmehr aus einer AlInGaAsP - Verbindung.

Die Figur 2c zeigt einen Querschnitt auf eine nicht erfindungsgemäße Ausführungsform als Vierfach-Solarzelle in einer dritten Alternative. Nachfolgend werden nur die Unterschiede zu der Ausführungsform, dargestellt in der Figur 2b, erläutert. Die vierte Teilzelle SC4 besteht aus einer GaInAs-Verbindung und ist zwischen dem Halbleiterspiegel HS1 und der zweiten Teilzelle SC2 ausgebildet, wobei die zweite Teilzelle SC2 nun eine Energiebandlücke zwischen 1.43 eV und 1.6 eV aufweist und aus einer AlInGaAsP - Verbindung besteht.

Die Figur 2d zeigt einen Querschnitt auf eine nicht erfindungsgemäße Ausführungsform als Vierfach-Solarzelle in einer vierten Alternative. Nachfolgend werden nur die Unterschiede zu der Ausführungsform, dargestellt in der Figur 2c, erläutert. Die vierte Teilzelle SC4 besteht aus einer GaInNAs-Verbindung und die zweite Teilzelle SC2 aus einer InGaAsP - Verbindung. Alle vier Teilzellen SC1, SC4, SC2 und SC3 sind nun zueinander Gitterangepasst und weisen im Wesentlichen die Gitterkonstante von Germanium auf. Anders ausgedrückt, die Mehrfach-Solarzelle MS weist keinen metamorphen Puffer MP1 auf.

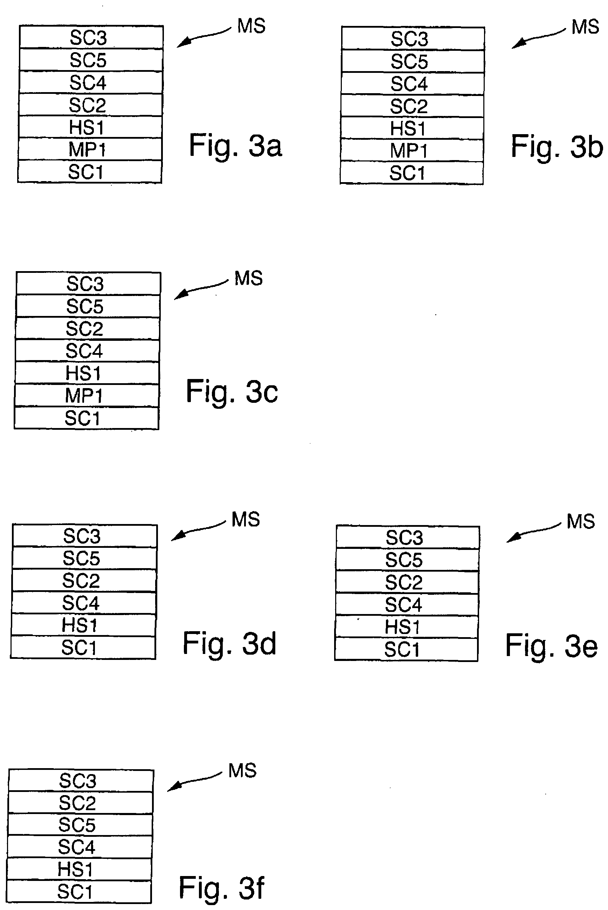

Die Figur 3a zeigt einen Querschnitt auf eine erfindungsgemäße Ausführungsform als Fünffach-Solarzelle in einer ersten Alternative. Nachfolgend werden nur die Unterschiede zu der Ausführungsform, dargestellt in der Figur 2a, erläutert. Zwischen der vierten Teilzelle SC4 und der dritten Teilzelle SC3 ist eine fünfte Teilzelle SC5 bestehend auf einer GaInP - Verbindung ausgebildet. Die Gitterkonstante der zweiten Teilzelle SC2, der vierten Teilzelle SC4, der fünften Teilzelle SC5 und der dritten Teilzelle SC3 sind zueinander angepasst, bzw. stimmen miteinander überein. Anders ausgedrückt, die Teilzellen SC2, SC4, SC5 und SC3 sind zueinander "gitterangepasst". Die fünfte Teilzelle SC5 weist eine größere Bandlücke als die vierte Teilzelle SC4 jedoch eine kleinere Bandlücke als die dritte Teilzelle SC3 auf.

Die Figur 3b zeigt einen Querschnitt auf eine erfindungsgemäße Ausführungsform als Fünffach-Solarzelle in einer zweiten Alternative. Nachfolgend werden nur die Unterschiede zu der Ausführungsform, dargestellt in der Figur 3a, erläutert. Die vierte Teilzelle SC4 besteht nunmehr aus einer AlInGaAsP - Verbindung.

Die Figur 3c zeigt einen Querschnitt auf eine nicht erfindungsgemäße Ausführungsform als Fünffach-Solarzelle in einer dritten Alternative. Nachfolgend werden nur die Unterschiede zu der Ausführungsform, dargestellt in der Figur 3b, erläutert. Die vierte Teilzelle SC4 besteht aus einer GaInAs-Verbindung und ist zwischen dem Halbleiterspiegel HS1 und der zweiten Teilzelle SC2 ausgebildet, wobei die zweite Teilzelle SC2 nun eine Energiebandlücke zwischen 1.3 eV und 1.4 eV aufweist und aus einer AlInGaAsP - Verbindung besteht.

Die Figur 3d zeigt einen Querschnitt auf eine nicht erfindungsgemäße Ausführungsform als Fünffach-Solarzelle in einer vierten Alternative. Nachfolgend werden nur die Unterschiede zu der Ausführungsform, dargestellt in der Figur 3c, erläutert. Die vierte Teilzelle SC4 besteht aus einer GaInNAs-Verbindung und ist zwischen dem Halbleiterspiegel HS1 und der zweiten Teilzelle SC2 ausgebildet, wobei die zweite Teilzelle SC2 nun eine Energiebandlücke zwischen 1.43 eV und 1.74 eV aufweist und aus einer InGaAsP - Verbindung besteht. Die fünfte Teilzelle SC5 besteht auf einer AlGaInAs - Verbindung. Alle fünf Teilzellen SC1, SC4, SC5 und SC3 sind nun zueinander gitterangepasst und weisen im Wesentlichen die Gitterkonstante von Germanium auf. Anders ausgedrückt, die Mehrfach-Solarzelle MS weist keinen metamorphen Puffer MP1 auf.

Die Figur 3e zeigt einen Querschnitt auf eine nicht erfindungsgemäße Ausführungsform als Fünffach-Solarzelle in einer fünften Alternative. Nachfolgend werden nur die Unterschiede zu der Ausführungsform, dargestellt in der Figur 3d, erläutert. Die fünfte Teilzelle SC5 besteht auf einer AlGaInAsP - Verbindung.

Die Figur 3e zeigt einen Querschnitt auf eine nicht erfindungsgemäße Ausführungsform als Fünffach-Solarzelle in einer sechsten Alternative. Nachfolgend werden nur die Unterschiede zu der Ausführungsform, dargestellt in der Figur 3e, erläutert. Die fünfte Teilzelle SC5 besteht aus einer GaInAs-Verbindung und ist zwischen der vierten Teilzelle SC4 und der zweiten Teilzelle SC2 ausgebildet, wobei die zweite Teilzelle SC2 aus einer AlInGaAsP - Verbindung besteht.

## Patentansprüche

1. Stapelförmige Mehrfach-Solarzelle (MS) mit fünf Teilzellen umfassend eine erste Teilzelle (SC1) wobei die erste Teilzelle (SC1) aus Germanium besteht oder zu mindestens 70% Germanium-aufweist, und
- eine zweite Teilzelle (SC2), wobei die zweite Teilzelle (SC2) eine größere Bandlücke als die erste Teilzelle (SC1) aufweist, und
- eine dritte Teilzelle (SC3), wobei die dritte Teilzelle (SC3) eine größere Bandlücke als die zweite Teilzelle (SC2) aufweist, und
- jede der Teilzellen (SC1, SC2, SC3) einen Emitter und eine Basis aufweist, und
- die zweite Teilzelle (SC2) eine Schicht mit einer Verbindung mit wenigstens den Elementen Ga und In und As und P umfasst und die Dicke der Schicht größer als 100 nm ist und die Schicht als Teil des Emitters und / oder als Teil der Basis und / oder als Teil der zwischen Emitter und Basis liegenden Raumladungszone ausgebildet ist, und die Gitterkonstante der Schicht kleiner 5,84 Ä ist, und
- die dritte Teilzelle (SC3) aus einer Schicht mit einer Verbindung mit wenigstens den Elementen Al und Ga und In und P besteht und die Dicke der Schicht größer als 100 nm ist und die Schicht als Teil des Emitters und / oder als Teil der Basis und / oder als Teil der zwischen Emitter und Basis liegenden Raumladungszone ausgebildet ist, und
eine vierte Teilzelle (SC4) und eine fünfte Teilzelle (SC5) ausgebildet sind,
- zwischen zwei Teilzellen kein Halbleiterbond ausgebildet ist, und
- die Teilzellen SC2, SC4, SC5 und SC3 zueinander gitterangepasst sind und die Gitterkonstanten der Schicht der dritten Teilzelle (SC3) sich von der Gitterkonstante der Schicht der zweiten Teilzelle (SC2) um weniger als 0,2% unterscheidet, wobei
- bei der zweiten Teilzelle (SC2) der Phosphor-Gehalt der Schicht größer 1% und kleiner 45% ist und der Indium-Gehalt der Schicht kleiner 50% ist, und
- zwischen der ersten Teilzelle (SC1) und der zweiten Teilzelle (SC2) ein metamorpher Puffer (MP1) ausgebildet ist, wobei der Puffer (MP1) eine Abfolge von mindestens drei Schichten aufweist und die Gitterkonstante bei der Abfolge in Richtung der zweiten Teilzelle (SC2) von Schicht zu Schicht ansteigt, und
- die vierte Teilzelle (SC4) eine größere Bandlücke als die zweite Teilzelle (SC2) jedoch eine kleinere Bandlücke als die dritte Teilzelle (SC3) aufweist, und die vierte Teilzelle (SC4) zwischen der zweiten Teilzelle (SC2) und der fünften Teilzelle (SC5) angeordnet ist und die fünfte Teilzelle (SC5) zwischen der vierten Teilzelle (SC4) und der dritten Teilzelle (SC3) angeordnet ist,
- die fünfte Teilzelle (SC5) eine größere Bandlücke als die vierte Teilzelle (SC4) jedoch eine kleinere Bandlücke als die dritte Teilzelle (SC3) aufweist,
- die fünfte Teilzelle (SC5) eine Schicht mit einer Verbindung aus wenigstens den Elementen Ga und In und P umfasst und die Dicke der Schicht größer als 100 nm ist und die Schicht als Teil des Emitters und / oder als Teil der Basis und / oder als Teil der zwischen Emitter und Basis liegenden Raumladungszone ausgebildet ist.

2. Mehrfach-Solarzelle (MS) nach Anspruch 1, **dadurch gekennzeichnet, dass** ein Halbleiterspiegel (HS1) ausgebildet ist und der Halbleiterspiegel (HS1) zwischen der ersten Teilzelle (SC1) und der zweiten Teilzelle (SC2) angeordnet ist.

3. Mehrfach-Solarzelle (MS) nach Anspruch 1 oder Anspruch 2, **dadurch gekennzeichnet, dass** die Schicht der zweiten Teilzelle (SC2) oder die Schicht der vierten Teilzelle (SC4) aus einer Verbindung mit wenigstens den Elementen Al und Ga und In und As und P besteht.

4. Mehrfach-Solarzelle (MS) nach einem der vorangegangenen Ansprüche, **dadurch gekennzeichnet, dass** die zweite Teilzelle als eine Hetero-Solarzellen mit einem Emitter bestehend aus GaInP und einer Raumladungszone und / oder Basis bestehend aus GaInAsP ausgebildet ist.

5. Mehrfach-Solarzelle (MS) nach einem der vorangegangenen Ansprüche, **dadurch gekennzeichnet, dass** die zweite Teilzelle (SC2) eine Energiebandlücke im Bereich von 1,3 eV bis 1,4 eV oder im Bereich von 1,43 eV bis 1,7 eV aufweist.

6. Mehrfach-Solarzelle (MS) nach einem der vorangegangenen Ansprüche, **dadurch gekennzeichnet, dass** bei der zweiten Teilzelle (SC2) der Phosphor-Gehalt der Schicht kleiner als 35% ist und der Indium-Gehalt der Schicht kleiner als 45% ist und / oder die Gitterkonstante der Schicht kleiner als 5,81 Ä ist.

7. Mehrfach-Solarzelle (MS) nach einem der vorangegangenen Ansprüche, **dadurch gekennzeichnet, dass** bei der zweiten Teilzelle (SC2) der Phosphor-Gehalt der Schicht (S2) kleiner als 25% ist und der Indium-Gehalt der Schicht kleiner als 45% ist und / oder die Gitterkonstante der Schicht kleiner als 5,78 Ä ist.

8. Mehrfach-Solarzelle (MS) nach einem der vorangegangenen Ansprüche, **dadurch gekennzeichnet, dass** bei der zweiten Teilzelle (SC2) die Dicke der Schicht größer als 0,4 µm oder größer als 0,8 µm ist.

9. Mehrfach-Solarzelle (MS) nach einem der vorangegangenen Ansprüche, **dadurch gekennzeichnet, dass** die zweite Teilzelle (SC2) keine Vielfach-Quantentopf-Struktur aufweist.

## Claims

1. Stacked multiple solar cell (MS) with five part cells comprising
- a first part cell (SC1), wherein the first part cell (SC1) consists of germanium or comprises at least 70% germanium, and
- a second part cell (SC2), wherein the second part cell (SC2) has a greater band gap than the first part cell (SC1), and
- a third part cell (SC3), wherein the third part cell (SC3) has a greater band gap than the second part cell (SC2), and
- each of the part cells (SC1, SC2, SC3) comprises an emitter and a base, and
- the second part cell (SC2) comprises a layer with a connection with at least the elements Ga and In and As and P and the thickness of the layer is greater than 100 nm and the layer is formed as part of the emitter and/or as part of the base and/or as part of the spatial charge zone lying between emitter and base, and the lattice constant of the layer is smaller than 5.84 Å, and
- the third part cell (SC3) consists of a layer with a connection with at least the elements Al and Ga and In and P and the thickness of the layer is greater than 100 nm and the layer is formed as part of the emitter and/or as part of the base and/or as part of the spatial charge zone lying between emitter and base, and
a fourth part cell (SC4) and a fifth part cell (SC5) are formed,
- no semiconductor bond is formed between two part cells, and
- the part cells SC2, SC4, SC5 and SC3 are lattice-matched to one another and the lattice constant of the layer of the third part cell (SC3) differs from the lattice constant of the layer of the second part cell (SC2) by less than 0.2%, wherein
- in the case of the second part cell (SC2) the phosphor content of the layer is greater than 1% and less than 45% and the indium content of the layer is less than 50%, and
- a metamorphic buffer (MP1) is formed between the first part cell (SC1) and the second part cell (SC2), wherein the buffer (MP1) has a sequence of at least three layers and the lattice constant increases from layer to layer in the sequence in the direction of the second part cell (SC2), and
- the fourth part cell (SC4) has a greater band gap than the second part cell (SC2), but a smaller band gap than the third part cell (SC3), and the fourth part cell (SC4) is arranged between the second part cell (SC2) and the fifth part cell (SC5) and the fifth part cell (SC5) is arranged between the fourth part cell (SC4) and the third part cell (SC3),
- the fifth part cell (SC5) has a greater band gap than the fourth part cell (SC4), but a smaller band gap than the third part cell (SC3),
- the fifth part cell (SC5) comprises a layer with a connection consisting of at least the elements Ga and In and P and the thickness of the layer is greater than 100 nm and the layer is formed as part of the emitter and/or as part of the base and/or as part of the spatial charge zone lying between emitter and base.

2. Multiple solar cell (MS) according to claim 1, **characterised in that** a semiconductor mirror (HS1) is formed and the semiconductor mirror (HS1) is arranged between the first part cell (SC1) and the second part cell (SC2).

3. Multiple solar cell (MS) according to claim 1 or claim 2, **characterised in that** the layer of the second part cell (SC2) or the layer of the fourth part cell (SC4) consists of a compound with at least the elements Al and Ga and In and As and P.

4. Multiple solar cell (MS) according to any one of the preceding claims, **characterised in that** the second part cell is formed as a hetero-solar cell with an emitter consisting of GaInP and a spatial charge zone and/or base consisting of GaInAsP.

5. Multiple solar cell (MS) according to any one of the preceding claims, **characterised in that** the second part cell (SC2) has an energy band gap in the range of 1.3 eV to 1.4 eV or in the range of 1.43 eV to 1.7 eV.

6. Multiple solar cell (MS) according to any one of the preceding claims, **characterised in that** in the case of the second part cell (SC2) the phosphor content of the layer is less than 35% and the indium content of the layer is less than 45% and/or the lattice constant of the layer is less than 5.81 Å.

7. Multiple solar cell (MS) according to any one of the preceding claims, **characterised in that** in the case of the second part cell (SC2) the phosphor content of the layer (S2) is less than 25% and the indium content of the layer is less than 25% and/or the lattice constant of the layer is less than 5.78 Å.

8. Multiple solar cell (MS) according to any one of the preceding claims, **characterised in that** in the case of the second part cell (SC2) the thickness of the layer is greater than 0.4 µm or greater than 0.8 µm.

9. Multiple solar cell (MS) according to any one of the preceding claims, **characterised in that** the second part cell (SC2) has a multiple quantum well structure.

## Revendications

1. Cellule solaire à jonctions multiples (MS) empilable dotée de cinq sous-cellules, comprenant une première sous-cellule (SC1), laquelle première sous-cellule (SC1) est constituée de germanium ou contient au moins 70% de germanium et
- une deuxième sous-cellule (SC2), laquelle deuxième sous-cellule (SC2) présente une plus grande bande interdite que la première sous-cellule (SC1), et
- une troisième sous-cellule (SC3), laquelle troisième sous-cellule (SC3) présente une plus grande bande interdite que la deuxième sous-cellule (SC2), et dans laquelle
- chacune des sous-cellules (SC1, SC2, SC3) comporte un émetteur et une base, et
- la deuxième sous-cellule (SC2) comprend une couche avec une liaison avec au moins les éléments Ga et In et As et P, l'épaisseur de cette couche étant supérieure à 100 nm et cette couche étant configurée comme une partie de l'émetteur et/ou comme une partie de la base et/ou comme une partie la zone de charge d'espace située entre l'émetteur et la base, et la constante de réseau de cette couche étant inférieure à 5,84 Å, et
- la troisième sous-cellule (SC3) est constituée d'une couche avec une liaison contenant au moins les éléments Al et Ga et In et P, l'épaisseur de cette couche étant supérieure à 100 nm et cette couche étant configurée comme une partie de l'émetteur et/ou comme une partie de la base et/ou comme une partie la zone de charge d'espace située entre l'émetteur et la base, et une quatrième sous-cellule (SC4) et une cinquième sous-cellule (SC5) sont formées,
- aucune liaison semi-conductrice n'est établie entre deux sous-cellules, et
- les sous-cellules SC2, SC4, SC5 et SC3 sont appariées réticulairement entre elles, la constante de réseau de la couche de la troisième sous-cellule (SC3) divergeant de la constante de réseau de la couche de la deuxième sous-cellule (SC2) de moins de 0,2%,
- dans la deuxième sous-cellule (SC2), la teneur en phosphore de la couche est supérieure à 1% et inférieure à 45% et la teneur en indium de la couche est inférieure à 50%, et
- un tampon métamorphique (MP1) est formé entre la première sous-cellule (SC1) et la deuxième sous-cellule (SC2), lequel tampon (MP1) présente une succession d'au moins trois couches et la constante de réseau dans cette succession augmente de couche en couche en direction de la deuxième sous-cellule (SC2), et
- la quatrième sous-cellule (SC4) présente une plus grande bande interdite que la deuxième sous-cellule (SC2) mais une plus petite bande interdite que la troisième sous-cellule (SC3), la quatrième sous-cellule (SC4) est agencée entre la deuxième sous-cellule (SC2) et la cinquième sous-cellule (SC5) et la cinquième sous-cellule (SC5) est agencée entre la quatrième sous-cellule (SC4) et la troisième sous-cellule (SC3),
- la cinquième sous-cellule (SC5) présente une plus grande bande interdite que la quatrième sous-cellule (SC4) mais une plus petite bande interdite que la troisième sous-cellule (SC3),
- la cinquième sous-cellule (SC5) comprend une couche avec une liaison constituée au moins des éléments Ga et et P, l'épaisseur de cette couche étant supérieure à 100 nm et cette couche étant configurée comme une partie de l'émetteur et/ou comme une partie de la base et/ou comme une partie la zone de charge d'espace située entre l'émetteur et la base.

2. Cellule solaire à jonctions multiples (MS) selon la revendication 1, **caractérisée en ce qu'**un miroir semi-conducteur (HS1) est formé et que ce miroir semi-conducteur (HS1) est agencé entre la première sous-cellule (SC1) et la deuxième sous-cellule (SC2).

3. Cellule solaire à jonctions multiples (MS) selon la revendication 1 ou la revendication 2, **caractérisée en ce que** la couche de la deuxième sous-cellule (SC2) ou la couche de la quatrième sous-cellule (SC4) est constituée d'une liaison contenant au moins les éléments Al et Ga et et As et P.

4. Cellule solaire à jonctions multiples (MS) selon une des revendications précédentes, **caractérisée en ce que** la deuxième sous-cellule (SC4) est configurée comme une cellule solaire à hétérojonction avec un émetteur constitué de GalnP et une zone de charge d'espace et/ou une base constituées de GaInAsP.

5. Cellule solaire à jonctions multiples (MS) selon une des revendications précédentes, **caractérisée en ce que** la deuxième sous-couche (SC2) présente une bande interdite d'énergie située entre 1,3 eV et 1,4 eV ou entre 1,43 eV et 1,7 eV.

6. Cellule solaire à jonctions multiples (MS) selon une des revendications précédentes, **caractérisée en ce que**, dans la deuxième sous-couche (SC2), la teneur en phosphore de la couche est inférieure à 35% et la teneur en indium de la couche est inférieure à 45% et/ou la constante de réseau de la couche est inférieure à 5,81 Å.

7. Cellule solaire à jonctions multiples (MS) selon une des revendications précédentes, **caractérisée en ce que**, dans la deuxième sous-couche (SC2), la teneur en phosphore de la couche (S2) est inférieure à 25% et la teneur en indium de la couche est inférieure à 45% et/ou la constante de réseau de la couche est inférieure à 5,78 Å.

8. Cellule solaire à jonctions multiples (MS) selon une des revendications précédentes, **caractérisée en ce que**, dans la deuxième sous-couche (SC2), l'épaisseur de la couche est supérieure à 0,4 µm ou supérieure à 0,8 µm.

9. Cellule solaire à jonctions multiples (MS) selon une des revendications précédentes, **caractérisée en ce que** la deuxième sous-cellule (SC2) ne présente pas de structure à puits quantiques multiples.
